# EUROPEAN PATENT APPLICATION

(11) **EP 2 453 466 A1**
(43) Date of publication of application: **16.05.2012**
(21) Application number: 10796932.1
(22) Date of filing: 15.02.2010
(51) Int. Cl.: H01L 21/205, C23C 16/455, C23C 16/509, H01L 31/04, H05H 1/46

(54) **VACUUM PROCESSING APPARATUS**

(30) Priority: 08.07.2009 JP 2009161947
(71) Applicant: Mitsubishi Heavy Industries, Ltd., Tokyo 108-8215 (JP)
(72) Inventor: TAKEUCHI, Yoshiaki, Tokyo 108-8215 (JP); NISHIMIYA, Tatsuyuki, Tokyo 108-8215 (JP); MIYAHARA, Hiroomi, Tokyo 108-8215 (JP); NAKAO, Sachiko, Tokyo 108-8215 (JP)
(74) Representative: Bongiovanni, Simone
(86) International application number: PCT/JP2010/052186
(87) International publication number: WO 2011/004621

(57) **Abstract**

To provide a vacuum processing apparatus that is capable of increasing the quality of a deposited film, increasing the area thereof, and increasing deposition speed. A discharge chamber (2) formed of a ridge waveguide having ridge electrodes that are disposed facing each other and that generate plasma therebetween; a gas supplying portion (10) that is disposed adjacent to the discharge chamber (2) and that supplies source gas, which is used to form the plasma, toward the ridge electrodes; a substrate (S) that is disposed at a position such that the gas supplying portion (10) is flanked by the substrate (S) and the discharge chamber (2) and that is subjected to the processing by the plasma; a low-pressure vessel (7) that accommodates thereinside at least the discharge chamber (2), the gas supplying portion (10), and the substrate (S); and an exhaust portion (9) that is communicated at a position in the low-pressure vessel (7) such that this position and the gas supplying portion (10) are disposed on either side of the discharge chamber (2), and that reduces the pressure inside the low-pressure vessel (7) are provided.

## Description

### Technical Field

The present invention relates to a vacuum processing apparatus, and particularly to a vacuum processing apparatus that performs processing (including dry etching) of a substrate by using plasma.

### Background Art

In general, in order to improve the production efficiency of thin-film solar cells, it is important to deposit a high-quality silicon thin film at high speed and with a large area. As a method of depositing such high-speed, large-area deposition, a deposition method using plasma CVD (chemical vapor deposition) has been known.

For example, an amorphous silicon film, which is the basic material of a thin-film solar cell, is manufactured with the plasma CVD method by using SiH₄ gas or a mixture of SiH₄ gas and hydrogen gas as a raw material. There are cases in which the amorphous silicon film is used in a single-layer structure, in a two-layer structure in tandem with microcrystalline silicon, and, also, in a three-layer structure with microcrystalline silicon. Accordingly, the performance of the amorphous silicon film is considered to have a large influence on the performance of a laminated thin-film silicon solar cell as a whole.

On the other hand, the performance of solar cells having amorphous silicon films (hereinafter, referred to as "a-Si solar cells") has been known to deteriorate due to photodegradation. Furthermore, because the degree of photodegradation increases when the amorphous silicon films is deposited at high speed, the stabilized performance of the a-Si solar cells, after the performance deterioration due to the photodegradation, is significantly lowered.
Due to this problem, there has been a problem in that it is difficult to increase the deposition speed of the amorphous silicon films for a-Si solar cells.

As one cause of the photodegradation, contamination of amorphous silicon films by multi-molecular Si (Si nanoclusters) generated by overdecomposition of SiH₄ has been reported.

As one method of preventing contamination of the amorphous silicon films by the multi-molecular Si, a method in which the frequency employed to generate plasma is changed from a conventional RF band (13 MHz) to a VHF band (several tens of megahertz) has been known. By generating plasma by employing the VHF band frequency, the deposition speed of the amorphous silicon film is improved and the photodegradation is inhibited.

However, in the deposition of amorphous silicon films by employing the VHF band frequency, although the photodegradation is inhibited, it is not adequate, and the performance of a-Si solar cells deteriorates beyond a tolerable level.

On the other hand, an a-Si solar cell manufacturing method has been proposed in which performance degradation is suppressed by taking advantage of the short lifetime of SiH₄ radicals, which are considered to be sources of Si nanoclusters, that is, by taking advantage of their high reactivity with the source gas (for example, see Patent Literature 1).

Specifically, plasma is generated between a cathode, which is a parallel-plate electrode, and a mesh-like electrode; a region where the plasma is generated serves as a gas decomposing region; and a substrate is disposed at a position separated from the mesh-like electrode.
By doing so, SiH₂ radicals and the source gas react before SiH₂ radicals diffuse to the substrate, and thus, Si nanoclusters are less likely to contaminate an amorphous silicon film.
As a result, with an amorphous single cell manufactured by this manufacturing method, very high performance, that is, stabilized efficiency of 9.3% after photodegradation, has been realized.

Furthermore, a manufacturing method of a-Si solar cells in which performance deterioration is suppressed by utilizing a flow of a source gas and the like has also been proposed (for example, see Non Patent Literature 1 and 2).

Specifically, a hollow-electrode type plasma generating portion is disposed inside a cylindrical casing, and a gas supplying portion from which the source gas is jetted toward the plasma generating portion is disposed at one end of the casing. On the other hand, the other end of the casing is connected to a vacuum pump, and evacuation is performed. The substrate is disposed at a position such that the gas supplying portion is flanked by the substrate and the plasma generating portion.

By doing so, the source gas supplied from the gas supplying portion is suctioned by the vacuum pump via the plasma generating portion. Thus, the Si nanoclusters generated at the plasma generating portion are also suctioned by the vacuum pump. Accordingly, it becomes less likely for the Si nanoclusters to contaminate the amorphous silicon film on the substrate.

### Citation List

### Patent Literature

{PTL 1} Japanese Unexamined Patent Application, Publication No. 2006-19593.

### Non Patent Literature

{NPL 1} K. Koga, H. Sato, W.M. Nakamaura, H. Miyahara, H. Matsuzaki, and M. Shiratani, "Effects of hydrogen dilution on a-Si:H deposition using silane hollow discharge", Proceedings of the 25th Symposium on Plasma Processing, January 23, 2008, p. 93-94.
{NPL 2} W.M. Nakamura, D. Shimokawa, H. Miyahara, K. Koga, and M. Shiratani, Spatial Profile of Deposition Rate of a-Si:H Films in Multi-Hollow Discharge Plasma Chemical Vapor Deposition, Transactions of the Materials Research Society of Japan, 32[2], 2007, p. 469-472.

### Summary of Invention

### Technical Problem

However, because the deposition speed is slow with the technique disclosed in Patent Literature 1 described above, there is a problem in that it is difficult to employ it in actual a-Si solar cell manufacturing.

With techniques disclosed in Non Patent Literatures 1 and 2, there is a problem in that it is difficult to increase the area of a substrate to which the deposition processing is applied.
This is because, with a method in which an ultra-high frequency of 60 MHz is applied to an electrode provided with numerous holes to generate hollow discharges at the holes, the use of the ultra-high frequency makes the electric field at the electrode nonuniform via the influence of standing waves and, in addition, even if a uniform electric field is formed, it is very difficult to maintain stable, uniform hollow discharges in the numerous holes.

The present invention has been conceived to solve the above-described problems, and an object thereof is to provide a vacuum processing apparatus that is capable of increasing the quality of a deposited film, increasing the area thereof, and increasing deposition speed.

### Solution to Problem

In order to achieve the above-described object, the present invention provides the following solutions.
A vacuum processing apparatus according to an aspect of the present invention includes a discharge chamber formed of a ridge waveguide having a pair of ridge electrodes that are disposed facing each other and that generate plasma therebetween; a gas supplying portion that supplies source gas, which is used to form the plasma, toward the pair of ridge electrodes; a substrate subjected to the processing by the plasma is applied; a low-pressure vessel that accommodates thereinside at least the discharge chamber, the gas supplying portion, and the substrate; and an exhaust portion that is communicated at a position in the low-pressure vessel such that this position and the substrate are disposed on either side of the discharge chamber, and that reduces the pressure inside the low-pressure vessel, wherein the gas supplying portion and the exhaust portion form a flow in a direction that moves away from the substrate in the discharge chamber.

With the aspect described above, the source gas is supplied toward the pair of ridge electrodes from the gas supplying portion, and fluid in the low-pressure vessel is exhausted by the exhaust portion; therefore, as a whole, a flow that moves away from the substrate is formed inside the discharge chamber. Accordingly, foreign objects (Si nanoclusters and the like when the source gas is SiH₄) that are generated simultaneously when the plasma is generated between the pair of ridge electrodes flow into the exhaust portion from the low-pressure vessel due to this flow.
On the other hand, because generated radicals with long lifetime move toward the substrate due to diffusion, the substrate is subjected to processing.

Furthermore, due to the properties of the ridge waveguide, the electric field strength distribution between the pair of ridge electrodes is made uniform. In addition, by employing the ridge waveguide, the area of a region where the electric field strength distribution is made uniform can be readily increased.
Accordingly, uniform plasma can be generated in a wide area with respect to the substrate.

With the aspect described above, it is desirable that a power source that supplies RF power to the discharge chamber; a coaxial line that is formed of an internal conductor and an external conductor and that guides the RF power from the power source to the discharge chamber; and converters that are formed of ridge waveguides having a pair of ridge portions, that are disposed next to each other in a direction in which the discharge chamber extends, and that guide the RF power to the discharge chamber from the coaxial line be additionally provided, and that the converters be accommodated inside the low-pressure vessel.

With the aspect described above, because the discharge chamber and the converters, which are adjacent to the discharge chamber, are disposed entirely inside the low-pressure vessel, the discharge chamber and the converters themselves do not have to possess strength for enduring a pressure differential. Accordingly, as compared with the case in which the discharge chamber and the converters themselves possess strength for enduring a pressure differential, the configurations of the discharge chamber and the converters can be simplified, and the configurations thereof are made more flexible.

With the aspect described above, it is desirable that a power source that supplies RF power to the discharge chamber; a coaxial line that is formed of an internal conductor and an external conductor and that guides the RF power from the power source to the discharge chamber; and converters that are formed of ridge wave guides having a pair of ridge portions, that are disposed next to each other in a direction in which the discharge chamber extends, and that guide the RF power to the discharge chamber from the coaxial line be additionally provided, and that the converters be disposed outside the low-pressure vessel, and window portions that maintain a depressurized state inside the low-pressure vessel be provided between the discharge chamber and the converters.

With the aspect described above, because the discharge chamber is disposed inside the low-pressure vessel, the discharge chamber itself does not need to possess strength for enduring a pressure differential. Accordingly, as compared with the case in which the discharge chamber itself possesses strength for enduring a pressure differential, the configuration of the discharge chamber can be simplified, and the configuration thereof is made more flexible.

Furthermore, as compared with the case in which the discharge chamber and the converters are disposed entirely inside the low-pressure vessel, the volume of the low-pressure vessel can be reduced. Accordingly, a depressurized state inside the low-pressure vessel is readily maintained.

On the other hand, because the converters are placed under atmospheric pressure, discharge is less likely to occur therein, as compared with the discharge chamber which is placed under the depressurized state. Accordingly, it becomes easier to generate a discharge only in the space between the pair of ridge electrodes that generate plasma.

With the aspect described above, it is desirable that, in the low-pressure vessel, the substrate be disposed so as to allow relative movement thereof, and a pair of opening portions be provided, through which the substrate is placed into and removed from the low-pressure vessel.

With the aspect described above, the substrate is placed between the pair of ridge electrodes from one of the pair of opening portions, and plasma processing can be applied to the substrate. Furthermore, the substrate to which the plasma processing has been applied can be removed from the other of the pair of opening portions.

By doing so, the placement of the substrate, the plasma processing of the substrate, and the removal of the substrate can be continuously performed. Accordingly, the plasma processing can be continuously applied to a substrate having a larger area than the pair of ridge electrodes, and the production efficiency can be improved.
Furthermore, even if the distribution of plasma formed between the pair of ridge electrodes is nonuniform, by performing the plasma processing while moving the substrate, the plasma processing is uniformly applied to the substrate.

On the other hand, because the interior of the discharge chamber where plasma is formed is separated from a region in which the substrate moves, the plasma is not disturbed by the movement of the substrate.

With the aspect described above, it is desirable that an adjusting portion that adjusts the flow rate of a fluid that is exhausted by the exhaust portion be provided in the interior of the low-pressure vessel between the discharge chamber and an opening that communicates with the exhaust portion.

With the aspect described above, the interior of the low-pressure vessel is divided into a region in which the discharge chamber, the gas supplying portion, and the substrate are disposed and a region that communicates with the exhaust portion. Then, the flow rate of a fluid that flows into the region that communicates with the exhaust portion is adjusted by the adjusting portion.
As a result, the depressurized state in the region in which the discharge chamber, where the plasma processing of the substrate is performed, is disposed is maintained uniform by the exhaust portion and the adjusting portion. Advantageous Effects of Invention

With the vacuum processing apparatus according to the present invention, because a substrate, a gas supplying portion and a discharge chamber are sequentially disposed inside a low-pressure vessel, and because an exhaust portion communicates with the low-pressure vessel at a position thereof such that this position and the gas supplying portion are disposed of either side of the discharge chamber, an advantage is afforded in that the quality of a deposited film is increased, the area thereof is increased, and deposition speed is increased.

### Brief Description of Drawings

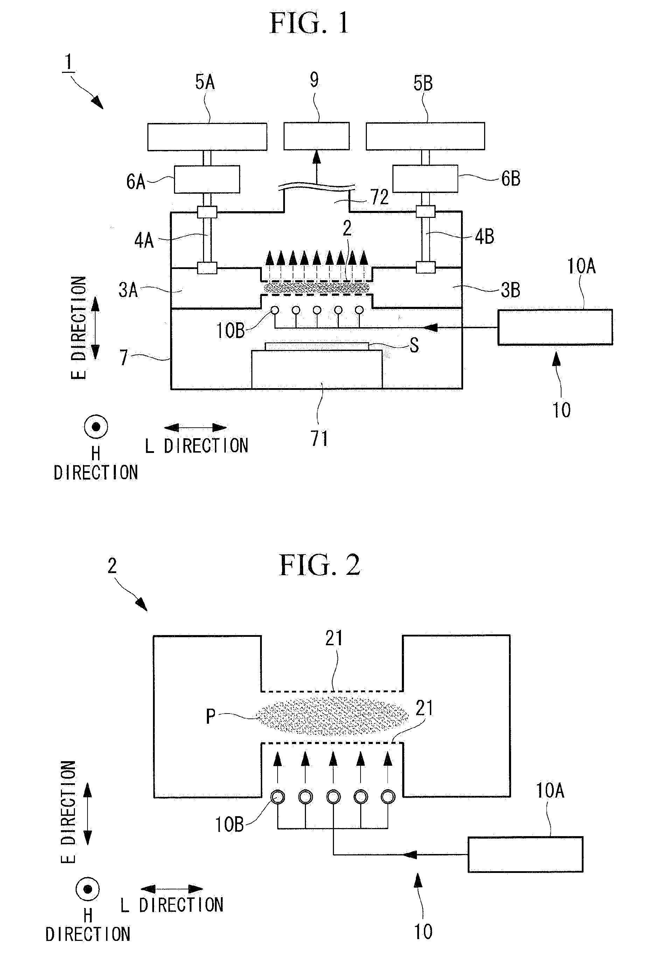

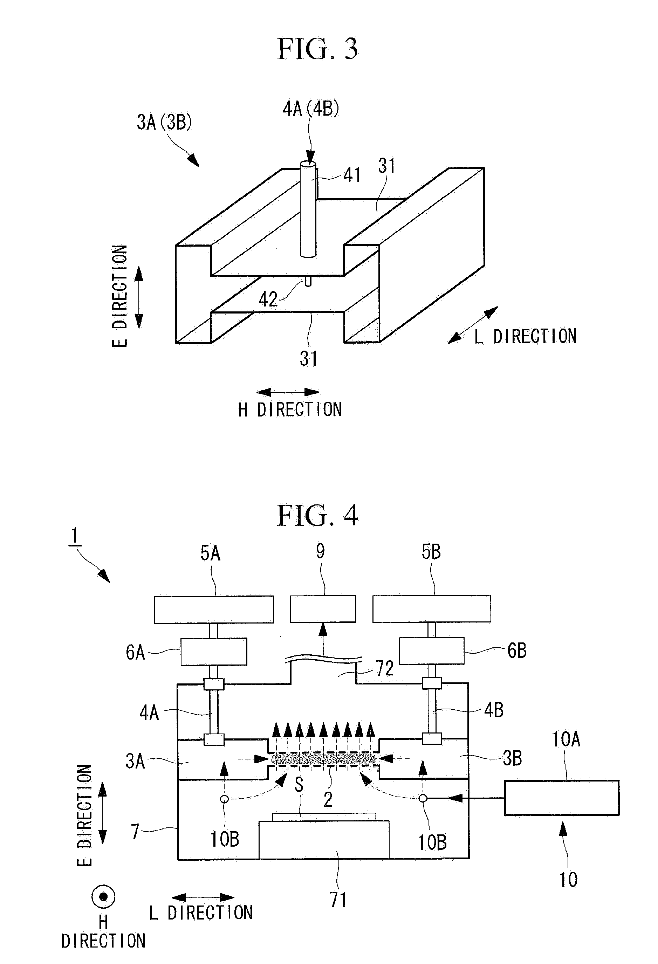

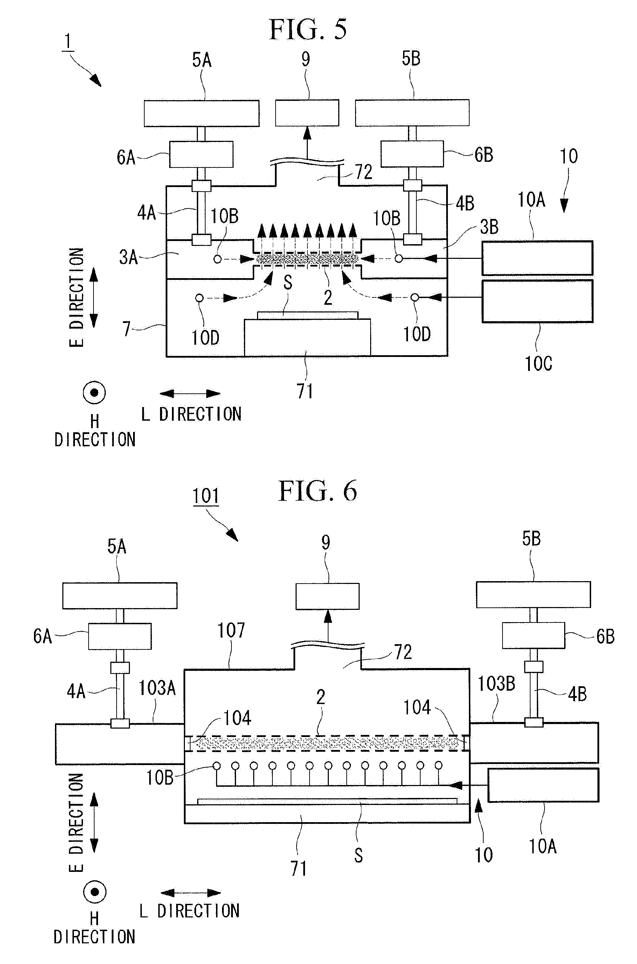

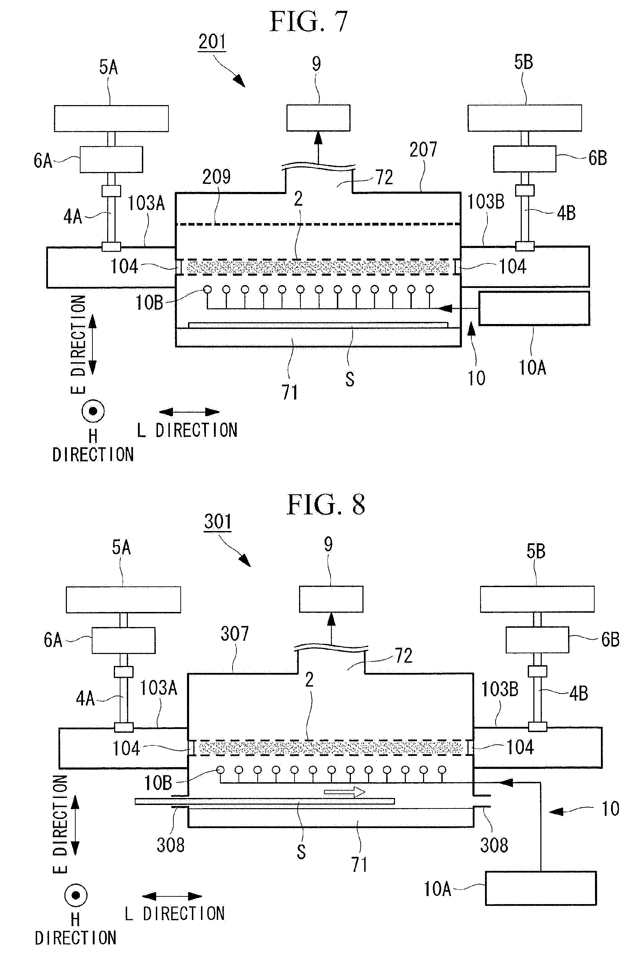

{Fig. 1} Fig. 1 is a schematic diagram for explaining, in outline, the configuration of a deposition apparatus according to a first embodiment of the present invention.
{Fig. 2} Fig. 2 is a partial sectional view for explaining the configuration of a processing chamber in Fig. 1.
{Fig. 3} Fig. 3 is a schematic diagram for explaining the configurations of a first converter and a second converter in Fig. 1.
{Fig. 4} Fig. 4 is a schematic diagram for explaining another example of the deposition apparatus in Fig. 1.
{Fig. 5} Fig. 5 is a schematic diagram for explaining yet another example of the deposition apparatus in Fig. 1.
{Fig. 6} Fig. 6 is a diagram for explaining, in outline, the configuration of a deposition apparatus according to a second embodiment of the present invention.
{Fig. 7} Fig. 7 is a diagram for explaining, in outline, the configuration of a deposition apparatus according to a third embodiment of the present invention.
{Fig. 8} Fig. 8 is a diagram for explaining, in outline, the configuration of a deposition apparatus according to a fourth embodiment of the present invention.

### Description of Embodiments

### First Embodiment

A deposition apparatus according to a first embodiment of the present invention will be described below with reference to Figs. 1 to 3.
Fig. 1 is a schematic diagram for explaining, in outline, the configuration of the deposition apparatus according to this embodiment. Fig. 2 is a partial sectional view for explaining a processing chamber in Fig. 1.

In this embodiment, a case will be described in which the present invention is applied to a deposition apparatus (vacuum processing apparatus) 1 that is capable of performing deposition processing of films formed of amorphous silicon, crystalline silicon such as microcrystalline silicon, silicon nitride and the like which are employed in amorphous solar cells, microcrystalline solar cells, TFTs (Thin Film Transistors) for liquid crystal displays and the like for a large-area substrate whose area is 1 m² or greater.

As shown in Fig. 1, the deposition apparatus 1 is mainly provided with a processing chamber (discharge chamber) 2, a first converter (converter) 3A, a second converter (converter) 3B, a first coaxial line (coaxial line) 4A, a first power source (power source) 5A, a first matching circuit 6A, a second coaxial line (coaxial line) 4B, a second power source (power source) 5B, a second matching circuit 6B, a vacuum vessel (low-pressure vessel) 7, an exhaust portion 9, and a gas supplying portion 10.

As shown in Fig. 1, the processing chamber 2 is a portion in which plasma processing is applied to a substrate S disposed thereinside.
The processing chamber 2 is a part formed of conductive and non-magnetic or weakly magnetic materials, such as aluminum, aluminum alloy materials and the like, and is formed in the shape of a so-called double-ridge waveguide.

As shown in Fig. 2, a pair of ridge electrodes 21 and 21 are provided in the processing chamber 2.
The pair of ridge electrodes 21 and 21 form ridge portions in the processing chamber 2 which is a double-ridge waveguide, and one ridge electrode 21 is disposed so as to face to other ridge electrode 21. Furthermore, a plurality of through-holes are formed in the ridge electrodes 21, like a mesh or perforated metal.

It is desirable that opening areas of the through-holes be designed to trap plasma between the pair of ridge electrodes 21 and 21.

Here, the direction in which the processing chamber 2 extends is defined as the L direction (left-right direction in Fig. 1), the direction in which magnetic lines of force extend, which is a direction perpendicular to the pair of ridge electrodes 21 and 21, is defined as the E direction (top-bottom direction in Fig. 1), and the direction along the pair of ridge electrodes 21 and 21, which is a direction perpendicular to the E direction, is defined as the H direction (a direction perpendicular to the plane of the drawing in Fig. 1).

Examples of the substrate S include a transparent glass substrate, which can be, for example, 1.4 m by 1.1 m in height and width and 3.0 mm to 4.5 mm in thickness.

As shown in Fig. 1, the first converter 3A and the second converter 3B are portions to which RF power supplied from the first power source 5A and the second power source 5B is introduced, respectively, and that transmit the supplied RF power to the processing chamber 2.
The first converter 3A and the second converter 3B convert the transmission mode of the RF power to a parallel-plate mode by utilizing properties of the ridge waveguide.

Fig. 3 is a schematic diagram for explaining the configuration of the first converter and the second converter in Fig. 1.
An internal conductor 41 in the first coaxial line 4A is electrically connected to one of a pair of ridge portions 31 and 31, for example, a lower ridge portion 31 in Fig. 3. An external conductor in the first coaxial line 4A is electrically connected to the other of the pair of ridge portions 31 and 31, for example, an upper ridge portion 31 in Fig. 3.

As shown in Fig. 1, the first coaxial line 4A and the second coaxial line 4B respectively guide the RF power supplied from the first power source 5A and the second 5B to the first converter 3A and the second converter 3B.
The first coaxial line 4A is electrically connected to the first power source 5A and the first matching circuit 6A. On the other hand, the second coaxial line 4B is electrically connected to the second power source 5B and the second matching circuit 6B.

As shown in Fig. 3, the internal conductors 41 and the external conductors 42 are provided in the first coaxial line 4A and the second coaxial line 4B.
The internal conductors 41 are formed of a conductor such as metal that extends like a rod or line. The external conductors 42 are formed of a conductor such as cylindrically formed metal inside of which the internal conductors 41 are disposed. Dielectrics (not shown) are disposed between the internal conductor 41 and the external conductor 42.
Known configurations can be employed as the configurations of the first coaxial line 4A and the second coaxial line 4B, and they are not particularly limited.

As shown in Fig. 1, the first power source 5A and the second power source 5B transmit the RF power to the processing chamber 2. They supply RF power with a frequency of, for example, 13.56 MHz or higher, preferably, 30 MHz to 400 MHz (VHF band to UHF band), and each is capable of adjusting the phase of the RF power to be supplied.
Because the size of the double-ridge waveguide becomes large at 13.56 MHz as compared with a conventional power supplying method employing a coaxial line, 30 MHz or higher is preferable in order to better utilize the features of the present invention. On the other hand, as the frequency becomes even higher, the influence of standing waves in the direction in which the processing chamber 2 extends becomes considerable; therefore, 400 MHz or lower is preferable.

The first power source 5A is electrically connected to the first coaxial line 4A and supplies the RF power to the first converter 3A via the matching circuit and the first coaxial line 4A. On the other hand, the second power source 5B is electrically connected to the second coaxial line 4B and supplies the RF power to the second converter 3B via the second coaxial line 4B.
The RF power supplied to the first converter 3A and the second converter 3B is transmitted to the processing chamber 2 after the transmission mode thereof is converted to the parallel-plate mode.
A known RF power source can be employed as the power source 5, and it is not particularly limited.

As shown in Fig. 1, a vacuum vessel 7 accommodates the processing chamber 2, the first converter 3A, the second converter 3B, gas introducing pipes 10B, described later, the substrate S, and the like.
The vacuum vessel 7 has a structure that can endure a pressure differential. For example, one formed of stainless steel (SUS material according to the JIS standard), general-structure rolled steel (SS material according to the JIS standard), or a configuration reinforced with ribs, and the like can be employed.

An exhaust portion 9 is connected to the vacuum vessel 7. Accordingly, the exhaust portion 9 forms a vacuum state of about 0.1 kPa to 10 kPa inside the vacuum vessel 7 and inside the processing chamber 2, the first converter 3A, and the second converter 3B.

A substrate support base 71 where the substrate S is disposed is provided inside the vacuum vessel 7. As shown in Fig. 1, the substrate support base 71 is disposed at a wall surface of the vacuum vessel 7, which is a wall surface (a wall surface at the bottom side in Fig. 1) opposing a wall surface where an opening 72, described later, that communicates with the exhaust portion 9 is formed.

The substrate support base 71 adjusts the temperature and temperature distribution of the substrate S disposed thereon. That is, the substrate support base 71 controls its own temperature by circulating temperature-controlled heat medium thereinside or by incorporating a temperature controlled heater thereinside, thus having approximately uniform temperature as a whole, and has a function of making the temperature of opposing electrodes 3, with which it is in contact, a uniform predetermined temperature.

The heat medium described above is non-conductive medium, and high-thermal-conductivity gas, such as hydrogen, helium and the like, fluorine-based inert liquid, inert oil, purified water, and so on, can be employed as the heat medium. Among these, use of fluorine-based inert liquid (for example, product names GALDEN, F05, or the like) is preferable because the pressure does not increase even in a range between 150 °C and 250 °C and control thereof is easy.

As shown in Fig. 1, the exhaust portion 9 depressurizes the processing chamber 2, the first converter 3A and the second converter 3B by exhausting air from the interior thereof until a vacuum state is established. The exhaust portion 9 communicates with the opening 72 formed at the wall surface of the vacuum vessel 7.
A known vacuum pump or the like can be employed as the exhaust portion 9, and it is not particularly limited.

As shown in Figs. 1 and 2, the gas supplying portion 10 supplies source gas (for example, SiH₄ gas and the like), which is employed to generate plasma and contains raw-material gas for depositing on the surface of the substrate S, between the pair of ridge electrodes 21 and 21.
A gas supply source 10A and gas introducing pipes 10B are provided in the gas supplying portion 10.

The gas supply source 10A is disposed at a position separated from the processing chamber 2 and the like, and supplies the source gas between the pair of ridge electrodes 21 and 21 via the gas introducing pipes 10B.
The gas introducing pipes 10B are connected to the gas supply source 10A and are disposed between the substrate support base 71 and the processing chamber 2 inside a vacuum-vessel wall 402A. Furthermore, the source gas is jetted from the gas introducing pipes 10B toward the pair of ridge electrodes 21 and 21 in the processing chamber 2.

Next, deposition processing, which is plasma processing of the substrate S, in the deposition apparatus 1 with the above-described configuration will be described.
As shown in Fig. 1, the substrate S is disposed on the substrate support base 71 inside the vacuum vessel 7. Then, gas, such as air, is exhausted from the interior of the vacuum vessel 7 by the exhaust portion 9. Because the interiors of the vacuum vessel 7 and the interior of the processing chamber 2, the first converter 3A, and the second converter 3B communicate via the through-holes formed in the pair of ridge portions 31 and 31, the gas is also exhausted from the interior of the processing chamber 2 and the like.

RF power whose frequency is 13.56 MHz or higher, preferably, between 30 MHz and 400 MHz, is supplied from the first power source 5A and the second power source 5B to the ridge electrodes 21 of the processing chamber 2, and the source gas, for example, SiH₄ and the like, is supplied between the pair of ridge electrodes 21 and 21 from the gas supplying portion 10.
At this time, the exhausting level of the exhaust portion is controlled, and the interior of the processing chamber 2 and the like, in other words, the space between the pair of ridge electrodes 21 and 21, is maintained in a vacuum state of approximately 0.1 kPa to 10 kPa.

The RF power supplied from the first power source 5A is transmitted to the first converter 3A by the first coaxial line 4A via the first matching circuit 6A. Values, such as impedance and the like, in the system that transmits the RF power are adjusted at the first matching circuit 6A. The transmission mode of the RF power is converted to the parallel-plate mode at the first converter 3A.
The RF power supplied to the first converter 3A is transmitted to the processing chamber 2, and an electric field is formed between the pair of ridge electrodes 21 and 21.

The RF power supplied from the second power source 5B is, as with the RF power supplied from the first power source 5A, transmitted to the second converter 3B, and the transmission mode thereof is converted to the parallel-plate mode. The RF power supplied to the second converter 3B is transmitted to the processing chamber 2, and an electric field is formed between the pair of ridge electrodes 21 and 21.

Standing waves are formed in the processing chamber 2 by the RF power supplied from the first power source 5A and the RF power supplied from the second power source 5B. If the phases of the RF power supplied from the first power source 5A and the second power source 5B are fixed at this time, the positions (phases) of the standing waves are fixed, and the electric field intensity distribution in the L direction in the pair of ridge electrodes 21 and 21 becomes biased.

Therefore, by adjusting the phases of the RF power supplied from at least one of the first power source 5A and the second power source 5B, the positions of the standing waves formed in the processing chamber 2 are adjusted. Accordingly, the electric field intensity distribution in the L direction in the pair of ridge electrodes 21 and 21 is made temporally uniform.

Specifically, the phases of the RF power supplied from the first power source 5A and the second power source 5B are adjusted so that the positions of the standing waves move in a sine wave, a triangular wave, or a step like manner in the L direction with the passage of time.
The range in which the standing waves move, the manner in which the standing waves move (sine wave like, triangular wave like, step like, etc.), and the phase adjustment cycle are optimized on the basis of the power distribution, the distribution of light emitted from the plasma, the plasma density distribution, the distribution of properties related to a deposited film and the like. The properties related to the film include film thickness, film quality, and properties of the film as semiconductor, such as solar cell and the like.

The source gas supplied from the gas supply source 10A of the gas supplying portion 10 is jetted from the gas introducing pipes 10B toward the processing chamber 2. The source gas flows into the space between the pair of ridge electrodes 21 and 21 via the through-holes formed in the ridge electrodes 21.

The source gas is ionized between the pair of ridge electrodes 21 and 21 and plasma is generated. Deposition seeds formed by the ionization of the source gas are stacked on the substrate S from the space between the pair of ridge electrodes 21 and 21 via the through-holes, and a film like an amorphous silicon layer, a crystalline silicon layer, and so on is deposited.
On the other hand, substances that cause quality deterioration in the deposited film, such as Si nanoclusters and the like formed between the pair of ridge electrodes 21 and 21, and substances not needed for deposition are exhausted from the interior of the vacuum vessel 7 with the exhaust portion 9.

In other words, with the exhausting by the exhaust portion 9 and jetting of the source gas by the gas introducing pipes 10B, a flow of gas is formed from the gas introducing pipes 10B toward the exhaust portion 9 via the processing chamber 2. The Si nanoclusters and the like formed by plasma are exhausted from the vacuum vessel 7 in this flow of gas. On the other hand, the deposition seeds generated by the plasma are stacked on the substrate S by diffusion, regardless of the flow of gas.

Next, test results of the deposition apparatus 1 with the above-described configuration will be described.
Deposition of an amorphous silicon (a-Si) layer by the deposition apparatus 1 was performed under the following conditions.
Specifically, source gas supplied to the deposition apparatus 1 was 100% SiH₄, and the source gas was supplied at a flow rate of 10 SLM (standard liter/min).
The internal pressure of the vacuum vessel 7 was maintained at 10 Pa, and RF power of 60 MHz was supplied to the pair of ridge electrodes 21 and 21 from the first power source 5A and the second power source 5B.
The substrate S was maintained at 220°C by the substrate support base 71.

In a deposition test for the a-Si layer performed under the above-described conditions, a deposition speed of 0.7 nm/s was obtained.
Densities of a-Si defects measured with CPM (constant photocurrent method) were 2 × 10¹⁵ defects/cc at an initial stage immediately after the deposition and 7 × 10¹⁵ defects/cc at a stage after photodegradation.

Next, single-cell efficiency of an a-Si solar cell having the a-Si layer described above will be described.
Here, the structure of the a-Si solar cell is, glass/TCO/p layer (B-doped a-SiC:H)/buffer layer (a-SiC:H)/i layer (a-Si, 250 nm)/n layer (P-doped pc-Si)/back electrode (ZnO/Ag).
The initial efficiency, which is the single cell efficiency immediately after the a-Si solar cell was manufactured, was 10.1%, and the efficiency after the photodegradation was 9.4%.

With the above-described configuration, the source gas is supplied toward the pair of ridge electrodes 21 and 21 from the gas introducing pipes 10B of the gas supplying portion 10, and gas in the vacuum vessel 7 is exhausted by the exhaust portion 9; therefore, as a whole, a flow from the substrate S to the processing chamber 2 is formed inside the vacuum vessel 7. Accordingly, foreign objects, such as Si nanoclusters and the like, formed simultaneously when plasma is generated between the pair of ridge electrodes 21 and 21 flow into the exhaust portion 9 from the vacuum vessel 7 due to this flow.

On the other hand, because the generated plasma moves toward the substrate S due to an electric potential difference, plasma processing is applied to the substrate S.
As a result, a high-quality film can be deposited by adjusting the flow direction of the source gas.

Due to the properties of the ridge waveguide, the electric field intensity distribution becomes uniform between the pair of ridge electrodes 21 and 21. By employing the ridge waveguide, the area of a region in which the electric field intensity is uniformly distributed can be readily increased.
Accordingly, uniform plasma can be generated in a wide area with respect to the substrate S, a high-quality film can be deposited with a large area, and deposition can be performed at high speed.

The above-described embodiment has been described as applied to an example in which the substrate S is disposed in the vacuum vessel 7 so as to extend in the horizontal direction (the left-right direction in Fig. 1); however, the substrate S may be disposed so as to extend in a vertical direction or an oblique direction, and it is not particularly limited.

Fig. 4 is a schematic diagram for explaining another example of the deposition apparatus in Fig. 1.
The positions where the gas introducing pipes 10B are disposed may be between the substrate S and the ridge electrodes 21, as shown in Figs. 1 and 2, or they may be between the first converter 3A and the substrate S and between the second converter 3B and the substrate S, as shown in Fig. 4; they are not particularly limited.

When the gas introducing pipes 10B are disposed at such positions, the source gas jetted toward the ridge electrodes 21 from the individual gas introducing pipes 10B flows into the space between the ridge electrodes 21. At a surface of the gas supply source 10B facing the ridge electrodes 21, a plurality of jetting holes for supplying the gas are provided along the H direction.
Thereafter, as in the above-described embodiment, Si nanoclusters and the like are exhausted from the interior of the vacuum vessel 7 by the exhaust portion 9 through the through-holes formed in the ridge electrodes 21; the deposition seeds move toward the substrate S by diffusion; and a thin film of amorphous silicon or crystalline silicon is formed on the substrate S.

Fig. 5 is a schematic diagram for explaining another example of the deposition apparatus in Fig. 1.
As shown in Fig. 5, the gas introducing pipes 10B may be disposed inside the first converter 3A and inside the second converter 3B and may be configured so that the source gas is jetted toward the space between the pair of ridge electrodes 2; they are not particularly limited.
In this case, it is desirable that carrier-gas introducing pipes 10D that individually jet carrier gas supplied from a carrier-gas supply portion 10C toward the ridge electrodes 2 be disposed between the first converter 3A and the substrate S and between the second converter 3B and the substrate S.

By doing so, the carrier gas jetted from the carrier-gas introducing pipes 10D flows into the space between the ridge electrodes 21 by being carried by the flow of gas moving toward the exhaust portion 9. At the same time, the source gas jetted from the gas introducing pipes 10B flows into the space between the ridge electrodes 21.
Thereafter, as in the above-described embodiment, Si nanoclusters and the like are exhausted from the interior of the vacuum vessel 7 by the exhaust portion 9 through the through-holes formed in the ridge electrodes 21; deposition seeds move toward the substrate S by diffusion; and a thin film of amorphous silicon or crystalline silicon is formed on the substrate S.

### Second Embodiment

Next, a second embodiment of the present invention will be described with reference to Fig. 6.
Although the basic configuration of a deposition apparatus of this embodiment is similar to that of the first embodiment, configurations of the processing chamber, the first converter, and the second converter differ from those of the first embodiment. Therefore, in this embodiment, only the vicinity of the processing chamber and the like will be described using Fig. 6, and the descriptions of other components and the like will be omitted.
Fig. 6 is a diagram for explaining, in outline, the configuration of a deposition apparatus according to a second embodiment of the present invention.
Components that are same as those in the first embodiment are given the same reference signs, and descriptions thereof will be omitted.

As shown in Fig. 6, a deposition apparatus (vacuum processing apparatus) 101 is mainly provided with the processing chamber 2, a first converter (converting portion) 103A, a second converter (converting portion) 103B, the first coaxial line 4A, the first power source 5A, the first matching circuit 6A, the second coaxial line 4B, the second power source 5B, the second matching circuit 6B, a vacuum vessel (low-pressure vessel) 107, the exhaust portion 9, and the gas supplying portion 10.

As shown in Fig. 6, the first converter 103A and the second converter 103B are portions into which the RF power supplied from the first power source 5A and the second power source 5B are introduced and that transmit the supplied RF power to the processing chamber 2.
The first converter 103A and the second converter 103B convert the transmission mode of the RF power to the parallel-plate mode by utilizing the properties of the ridge waveguide.

As compared with the first converter 3A and the second converter 3B of the first embodiment, the first converter 103A and the second converter 103B differ in that they are disposed outside of the vacuum vessel 107, and the interiors thereof are not depressurized but are set to atmospheric pressure.

Vacuum windows (window portions) 104 are disposed between the first converter 103A and the processing chamber 2 and between the second converter 103B and the processing chamber 2.
The vacuum windows 104 maintain the vacuum state in the interior of the processing chamber 2 and do not inhibit the transmission of the RF power between the first converter 103A and the processing chamber 2 and between the second converter 103B and the processing chamber 2.
As materials for forming the vacuum windows 104, materials formed of those commonly employed as vacuum windows, such as quartz glass, can be employed; they are not particularly limited.

As shown in Fig. 6, the vacuum vessel 107 accommodates the processing chamber 2, the gas introducing pipes 10B, the substrate S and the like. That is, it differs from the vacuum vessel 7 in the first embodiment in that the first converter 103A and the second converter 103B are not accommodated therein.
The vacuum vessel 107 has a structure that can endure a pressure differential between the interior and the exterior of the vacuum vessel 107. For example, a structure formed of stainless steel (SUS material according to the JIS standard), general-structure rolled steel (SS material according to the JIS standard) or a configuration reinforced with a rib and the like can be employed.

The vacuum vessel 107 is provided with the opening 72 that is connected to the exhaust portion 9. Because of this, the interior of the vacuum vessel 107 and the interior of the processing chamber 2 are set to the vacuum state of approximately 0.1 kPa to 10 kPa by the exhaust portion 9.

With regard to the deposition processing, which is the plasma processing of the substrate S, in the deposition apparatus 101 with the above-described configuration, a description thereof will be omitted because it is the same as that in the first embodiment.

With the above-described configuration, because the processing chamber 2 is disposed inside the vacuum vessel 107, the processing chamber itself does not have to have strength to endure the pressure differential. Accordingly, as compared with the case in which the processing chamber 2 itself possesses strength to endure the pressure differential, the configuration of the processing chamber 2 can be simplified, and the configuration of the processing chamber 2 can be more flexible.

As compared with the case in which the processing chamber 2, the first converter 103A, and the second converter 103B are entirely disposed inside the vacuum vessel 107, the volume of the vacuum vessel 107 can be reduced. Accordingly, the vacuum state inside the vacuum vessel 107 can be readily maintained.

On the other hand, because the first converter 103A and the second converter 103B are under atmospheric pressure, discharge is less likely to occur as compared with the case in which they are under a vacuum state. Accordingly, it becomes easier to generate discharge only in the space between the pair of ridge electrodes 21 and 21 where plasma is to be generated.

### Third Embodiment

Next, a third embodiment of the present invention will be described with reference to Fig. 7.
Although the basic configuration of a deposition apparatus of this embodiment is similar to that of the second embodiment, the configuration of the vacuum vessel differs from that of the second embodiment. Therefore, in this embodiment, only the configuration of the vacuum vessel will be described using Fig. 7, and the descriptions of other components, etc. will be omitted.
Fig. 7 is a diagram for explaining, in outline, the configuration of a deposition apparatus according to this embodiment.
Components that are same as those in the second embodiment are given the same reference signs, and descriptions thereof will be omitted.

As shown in Fig. 7, a deposition apparatus (vacuum processing apparatus) 201 is mainly provided with the processing chamber 2, the first converter 103A, the second converter 103B, the first coaxial line 4A, the first power source 5A, the first matching circuit 6A, the second coaxial line 4B, the second power source 5B, the second matching circuit 6B, a vacuum vessel (low-pressure vessel) 207, the exhaust portion 9, and the gas supplying portion 10.

As shown in Fig. 7, the vacuum vessel 207 accommodates the processing chamber 2, the gas introducing pipes 10B, the substrate S and the like.
The vacuum vessel 207 has a structure that can endure a pressure differential. For example, a structure formed of stainless steel (SUS material according to the JIS standard), general-structure rolled steel (SS material according to the JIS standard) or a configuration reinforced with a rib and the like can be employed.

The vacuum vessel 207 is provided with the opening 72 that is connected to the exhaust portion 9 and is also provided with an exhaust adjusting plate (adjusting portion) 209.
The exhaust adjusting plate 209 makes the pressure conditions uniform in a region in the vacuum vessel 207 where the processing chamber 2 and the substrate S are disposed.

The exhaust adjusting plate 209 is a plate-like member in which a plurality of through-holes are formed. For example, perforated metal, a mesh and the like can be employed as the exhaust adjusting plate 209.
The exhaust adjusting plate 209 is disposed between the processing chamber 2 and the opening 72. Because of this, the interior of the vacuum vessel 207 is divided into a region that communicates with the opening 72 (a region on the upper side in Fig. 7) and a region where the processing chamber 2 and the substrate S are disposed (a region on the lower side in Fig. 7).

With regard to the deposition processing, which is the plasma processing of the substrate S, in the deposition apparatus 201 with the above-described configuration, a description thereof will be omitted because it is the same as that in the second embodiment.

With the above-described configuration, the interior of the vacuum vessel 207 is divided by the exhaust adjusting plate 209 into the region where the processing chamber 2, gas introducing pipes 10B, the substrate S and the like are disposed and the region that communicates with the exhaust portion 9. Then, the flow rate of the source gas and the like that flows into the region that communicates with the exhaust portion 9 from the region in which the processing chamber 2 and the like are disposed is adjusted by the exhaust adjusting plate 209. Consequently, the pressure distribution in the region in which the processing chamber 2 and the like are disposed is made uniform.
As a result, the vacuum state in the region in which the processing chamber 2 and the like are disposed, where the plasma processing of the substrate S is performed, can be maintained uniform by the exhaust portion 9 and the exhaust adjusting plate 209.

### Fourth Embodiment

Next, a fourth embodiment of the present invention will be described with reference to Fig. 8.
Although the basic configuration of a deposition apparatus of this embodiment is similar to that of the second embodiment, the configuration with regard to placement and removal of the substrate differs from that of the second embodiment. Therefore, in this embodiment, only the configuration with regard to the placement and the removal of the substrate will be described using Fig. 8, and the descriptions of other components, etc. will be omitted.
Fig. 8 is a diagram for explaining, in outline, the configuration of a deposition apparatus according to this embodiment.
Components that are same as those in the second embodiment are given the same reference signs, and descriptions thereof will be omitted.

As shown in Fig. 8, a deposition apparatus (vacuum processing apparatus) 301 is mainly provided with the processing chamber 2, the first converter 103A, the second converter 103B, the first coaxial line 4A, the first power source 5A, the first matching circuit 6A, the second coaxial line 4B, the second power source 5B, the second matching circuit 6B, a vacuum vessel (low-pressure vessel) 307, the exhaust portion 9, and the gas supplying portion 10.

As shown in Fig. 8, the vacuum vessel 307 accommodates the processing chamber 2, the gas introducing pipes 10B, the substrate S and the like.
The vacuum vessel 307 has a structure that can endure a pressure differential. For example, a structure formed of stainless steel (SUS material according to the JIS standard), general-structure rolled steel (SS material according to the JIS standard) or a configuration reinforced with a rib and the like can be employed.

At portions that are wall surfaces of the vacuum vessel 307 and that intersect with the direction in which the substrate S extends (H direction), a pair of slits (opening portions) 308 and 308 are provided, from which the substrate S is placed into the vacuum vessel 307 or removed from the vacuum vessel 307.
The pair of the slits 308 and 308 are through-holes that are formed in substantially rectangular shapes at the wall surfaces of the vacuum vessel 307, and they are the holes through which the substrate S is placed or removed.

In this embodiment, the same substrate S as in the first embodiment or a substrate S formed with a longer size can be employed.
As the materials for the substrate S, in addition to a transparent glass substrate, it is possible to employ flexible materials that can be rolled up. In this case, a roll-to-roll type deposition processing can be performed by using the deposition apparatus 301 of this embodiment.

With regard to the deposition processing, which is the plasma processing of the substrate S, in the deposition apparatus 301 with the above-described configuration, a description thereof will be omitted because it is the same as that in the second embodiment.

With the above-described configuration, the substrate S is placed between the pair of ridge electrodes 21 and 21 through one of the pair of slits 308 and 308, and plasma processing, such as deposition processing and the like can be applied to the substrate S. Furthermore, the substrate S to which the deposition processing has been applied can be removed from the other of the pair of slits 308 and 308.

Accordingly, the placement of the substrate S, the deposition processing of the substrate S, and the removal of the substrate S can be continuously performed. Accordingly, the deposition processing can be continuously applied to a substrate S having a larger area than the pair of ridge electrodes 21 and 21, and the production efficiency can be improved.

Even if the plasma is nonuniformly formed between the pair of ridge electrodes 21 and 21, by performing the deposition processing while moving the substrate S, the deposition processing is uniformly applied to the substrate S, and thus, a uniform film is deposited.

On the other hand, because the space between the ridge electrodes 21 and 21 where plasma is formed is separated from a region in which the substrate S moves, plasma is not disturbed by the movement of the substrate S. Accordingly, the deposition processing can be uniformly applied to the substrate S.

The technical scope of the present invention is not limited to the above-described embodiments, and various alterations are possible within a range that does not depart from the spirit of the present invention.
For example, in the above-described embodiments, the present invention has been described as applied to deposition apparatuses employing the plasma CVD method; however, the present invention is not limited to deposition apparatuses, and it can be applied to various other apparatuses including apparatuses that perform plasma processing such as plasma etching and the like.

### Reference Signs List

1, 101, 201, 301 deposition apparatus (vacuum processing apparatus)
2 processing chamber (discharge chamber)
3A, 103A first converter (converter)
3B, 103B second converter (converter)
4A first coaxial line (coaxial line)
4B second coaxial line (coaxial line)
5A first power source (power source)
5B second power source (power source)
7, 107, 207, 307 vacuum vessel (low-pressure vessel)
21 ridge electrode
41 internal conductor
42 external conductor
104 vacuum window (window portion)
209 exhaust adjusting plate (adjusting portion)
308 pair of slits (opening portions)
S substrate

## Claims

1. A vacuum processing apparatus comprising:
a discharge chamber formed of a ridge waveguide having ridge electrodes that are disposed facing each other and that generate plasma therebetween;
a gas supplying portion that supplies source gas, which is used to form the plasma, toward the ridge electrodes;
a substrate subjected to the processing by the plasma is applied;
a low-pressure vessel that accommodates thereinside at least the discharge chamber, the gas supplying portion, and the substrate; and
an exhaust portion that is communicated at a position in the low-pressure vessel such that this position and the substrate are disposed on either side of the discharge chamber, and that reduces the pressure inside the low-pressure vessel,
wherein the gas supplying portion and the exhaust portion form a flow in a direction that moves away from the substrate in the discharge chamber.

2. A vacuum processing apparatus according to Claim 1, further comprising:
a power source that supplies RF power to the discharge chamber;
a coaxial line that is formed of an internal conductor and an external conductor and that guides the RF power from the power source to the discharge chamber; and
converters that are formed of ridge waveguides having ridge portions, that are disposed next to each other in a direction in which the discharge chamber extends, and that guide the RF power to the discharge chamber from the coaxial line;
wherein the converters are accommodated inside the low-pressure vessel.

3. A vacuum processing apparatus according to Claim 1, further comprising:
a power source that supplies RF power to the discharge chamber;
a coaxial line that is formed of an internal conductor and an external conductor and that guides the RF power from the power source to the discharge chamber; and
converters that are formed of ridge wave guides having ridge portions, that are disposed next to each other in a direction in which the discharge chamber extends, and that guide the RF power to the discharge chamber from the coaxial line;
wherein the converters are disposed outside the low-pressure vessel, and window portions that maintain a depressurized state inside the low-pressure vessel are provided between the discharge chamber and the converters.

4. A vacuum processing apparatus according to any one of Claims 1 to 3, wherein, in the low-pressure vessel, the substrate is disposed so as to allow relative movement thereof, and a pair of opening portions are provided, through which the substrate is placed into and removed from the low-pressure vessel.

5. A vacuum processing apparatus according to any one of Claims 1 to 4, wherein an adjusting portion that adjusts the flow rate of a fluid that is exhausted by the exhaust portion is provided in the interior of the depressurized chamber between the discharge chamber and an opening that communicates with the exhaust portion.
